# EUROPEAN PATENT SPECIFICATION

(11) **EP 0 305 515 B1**
(45) Date of publication and mention of the grant of the patent: **15.06.1994**
(21) Application number: 88904740.3
(22) Date of filing: 16.03.1988
(51) Int. Cl.: H01L 39/12

(54) **DEVICES AND SYSTEMS BASED ON NOVEL SUPERCONDUCTING MATERIAL**
ANORDNUNGEN UND SYSTEME, BASIEREND AUF NEUEM SUPRALEITENDEM MATERIAL
DISPOSITIFS ET SYSTEMES BASES SUR UN NOUVEAU MATERIAU SUPRACONDUCTEUR

(30) Priority: 18.03.1987 US 27371
(43) Date of publication of application: 08.03.1989
(73) Proprietor: AT&T Corp., New York, NY 10013-2412 (US)
(72) Inventor: BATLOGG, Bertram, Josef, New Providence, NJ 07974 (US); CAVA, Robert, Joseph, Basking Ridge, NJ 07920 (US); VAN DOVER, Robert, Bruce, Berkeley Heights, NJ 07922 (US)
(74) Representative: Johnston, Kenneth Graham
(86) International application number: PCT/US88/00838
(87) International publication number: WO 88/07264

(56) References cited:
- Zeitschrift für Physik B - Condensed Matter, volume 66, 10 March 1987, Springer-Verlag, C. Politis et al.: "Superconductivity at 40 K in La1.8Sr0.2CuO4", pages 141-146
- Physical Review Letters, volume 58, no. 18, 4 May 1987, The American Physical Society, D. W. Murphy et al.: "New superconducting cuprate perovskites", pages 1888-1890
- Japanese Journal of Applied Physics, volume 26, no. 5, May 1987, T. Wada et al.: "Substitution effect of Sr for BA of High-Tc superconducting YBa2Cu3O7-y ceramics", pages L706-L708
- Revue de Chimie minérale, t. 21, 1984, pp. 407-425 (Michel & Raveau)
- Physicals Review Letters, vol. 58, no. 9, 2 March 1987, pp. 908-910

## Description

The invention relates to cuprate superconductors.

The interplay between various properties of materials in their non-superconducting state, such as ρ, the resistivity, and γ, and their superconducting properties such as H_{c2}, the upper critical field, has been examined intensively since 1959, beginning with the work of Gorkov, who first related the microscopic theory of Bardeen-Cooper-Schrieffer (BCS) to the phenomenological theory of Ginzburg-Landau (G-L), and extended significantly by Abrikosov, to explain the properties of technologically important materials. This accumulation of knowledge is referred to as Ginzburg-Landau-Abrikosov-Gorkov (GLAG) theory and has been refined and extended by many investigators. The relationship between some important superconducting properties and normal state parameters was recently summarized by Orlando, McNiff, Foner & Beasley, (Physical Review, B19, page 4545, 1979). There it is shown that in Nb₃Sn, a superconducting material which has been employed in the highest-field magnets currently in operation, the upper critical field at, e.g., 4.2K, can be significantly improved by increasing the resistivity of the material, albeit at the expense of a reduction in T_{c}, the critical temperature. This reduction in T_{c} is likely responsible for the fact that the described increase in upper critical magnetic field has not received more serious attention. As far as can be determined, superconducting devices based on the A-15 compounds have not taken advantage of increased field values due to mixed cation occupancy.

A resurgence in interest in superconductivity worldwide is ascribable to the emergence of substituted copper oxide superconductors, the most significant of which show high critical temperatures--many in a range amenable to liquid nitrogen cooling. Exemplary materials of this "perovskite" class are completely superconducting at temperatures in the range of 90-100K, temperatures sufficiently removed from liquid nitrogen temperature to permit attainment of significant superconducting properties (R. J. Cava et al, Physical Review Letters, Vol. 58, page 1676, and D. W. Murphy et al, ibid, page 1888).

According to the present invention, there is provided an article as defined in claim 1.

This invention originated in the investigation of the properties of various examples of the phases described in a previous application. It was noticed that certain substitutions in the quaternary perovskite phases led to greatly enhanced high-field properties which are correlated to the increase in resistivity.
enhanced high-field properties which are correlated to the increase in resistivity. While the GLAG formulation of the microscopic theory may not be obeyed in detail in these materials (e.g., if the superconductivity is not due to the usual electron-phonon interaction), the interplay between ρ and H_{c2} may nevertheless be qualitatively similar.

In contrast to work described in the "Background", it has been found that chemical substitutions made in perovskite copper oxide-based superconductors may give rise to increased values of the critical magnetic field for given current density or, conversely, increased current density for given values of magnetic field or combination of increased values of both. Unlike prior work reported under "Background of the Invention", substitutions in accordance with the invention have no significant effect on the temperature of the onset of superconductivity (i.e., the value of T_{c} is not significantly changed).

The category of materials to which the invention applies is that of U. S. patent Serial No. 024,046, (filed March 10, 1987). The category of materials so encompassed and as described in the cited application is set forth under the Detailed Description herein.

The invention depends upon the finding that mixed occupancy, by M or M' elements within the general formulation M₃₋ₘM$\frac{\text{'}}{\text{m}}$Cu₃Oₓ (x typically between about 6.5 and 7.5), under the constraints set forth, gives rise to an increase in critical magnetic field and/or current density under any given set of real operating conditions.

Simply stated, the inventive finding is to the effect that mixed occupancy in the "A" site, as described, gives rise to a critical field value increase for any given temperature. (The "A" site is occupied by the M and M' elements and refers to the conventional "ABO₃" designation for the primitive cell in the perovskite structure.) In terms of utilization this may take a variety of significant forms including:
1) Magnet structures capable of producing increased field,
2) Magnet structures of reduced size for a given required field,
3) Any other use in which superconducting properties are limited by magnetic field (circuitry might be subjected to a significant field due to proximity to a high field magnet or for whatever other reason). Stated differently, the inventive advance may be expressed in terms of higher permitted current density for any given magnetic environment.

For descriptive purposes, compositions of the invention are described in terms of prototypical compositions in which the A site in the "pure" compound is populated by but a single divalent ion species, e.g., Ba, and but a single trivalent ion species, e.g., Y, Eu, or La. Improvement in critical magnetic field of at least about 5% under given operating conditions corresponds with introduction ions of a third (and possibly fourth, ...) atomic species into the A site (into the M and/or M' location ) by an amount of at least about 1 atomic %, based on the total number of atoms in the A site. More preferred limitations correspond with critical field improvements of at least 10% corresponding with inclusion of at least about 2 atomic % of third (fourth, ...) atomic species into the A site. Realization of critical field improvement at given operating conditions of 100% or more corresponds with mixed A site occupancy in which a third (fourth, ...) ion is included in amount of at least 10 atomic % based on the total number of (M and M') ions in the A site.

The invention consists of the optimization of the properties of cuprate superconductors by partial substitution. Nominal compositions of the inventive materials may be represented by the nominal formula M_{2-y}M'_{1-z}X_{y+z}Cu₃Oₓ (x typically between about 6.5 and 7.5), where M=Ba, M' is one of Y, Eu, or La, and X is at least one element different from M or M', and is one of elements 57-71 or Y, Sc, Ca or Sr. In general, significant increase in H_{c2} corresponds with z+y values of from 0.03 to 1.0, with the provision that both M and M' be at least 50 atomic % unsubstituted. The choice of substitution element X and amount z+y is dictated by the increase in resistivity which is sought. An important aspect of this invention is that, for many of the substitutions, the increase in resistivity does not come at the expense of a significant decrease in T_{c}, as viewed in terms of the prototypical reference compound of unsubstituted M/M' composition. Other variations in the unsubstituted compounds--particularly variations from the nominal formula-are set forth in the above-referred to U. S. patent application.

In a general sense the invention is a superconducting element comprising a body that comprises at least one essentially single-phase superconducting composition that has nominally perovskite structure and is a quaternary copper oxide of nominal formula M₂M'Cu₃O_{9-δ} (1.5 < δ < 2.5), in which the M ions are essentially divalent, the M' ions are essentially trivalent, with divergence from the nominal formula amounts of M and M' being at most 10 atomic percent, and in which the M and M' ions primarily occupy a crystallographic site equivalent to the "A" site in the prototypical ABO₃ perovskite structure. In the inventive composition at least three chemically distinct atomic species populate the A-site (i.e., at least one of M and M' signifies at least two chemically distinct elements), such that the upper critical field H_{c2} of the inventive composition is at least 10% increased relative to that of the prototypical reference composition wherein the A-site is populated by only the two major chemical elements of M and M'. Typically both the inventive and the prototypical reference composition have substantially the same T_{c}.

More specifically, the invention is the above superconducting element wherein M and M' are chosen from the group consisting of Ba, Y, Eu, Sc, Ca, Sr, and the elements of atomic number 57-71.

### Definitions

While the terminology used in the description is well known to the artisan, it is convenient to set it forth:
H_{c1} -- Critical field value at which the Meisner effect is complete (magnetic flux is totally excluded).

H_{c2} -- Critical field value above which all evidence of superconductivity is absent. (This term is meaningful in Type II superconductivity to which the invention is restricted in which real operation at values intermediate H_{c1} and H_{c2} correspond with superconducting conditions under which supercurrents are actually carried, even though the entire cross-section of the material may include local regions which are non-superconducting). 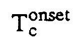
-- This is the temperature at which there is initial evidence of superconductivity, e.g., in terms of a significant change in slope of resistivity as a function of temperature. 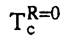
-- The value of temperature at which there is a continuous path between applied electrodes such that the measured resistance between electrodes is zero. 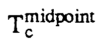
-- The value of temperature which is equidistant between 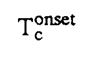
and 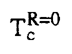
in terms of resistance expressed.

J_{c} -- critical current which, as in usual terms, defines the maximum current at which the sample is superconducting under given conditions (temperature and field).

### Brief Description of the Drawing

FIG. 1 is a diagrammatic representation of the ideal cubic perovskite structure. As described further on, it serves as a basis for structures in this invention which may entail distortions to lower symmetry and/or deviations from nominal stoichiometry.

FIGS. 2 and 3, on coordinates of resistivity and temperature, plot characteristics of materials made in accordance with the Examples on different coordinate scales. The curve form is useful in identification of the various values of T_{c} as the term is used in the art.

FIG. 4, on coordinates of magnetic field and temperature, plots the superconducting phase boundary for unsubstituted and an exemplary substituted material in accordance with the invention. The dashed lines represent rough extrapolations of the data.

FIG. 5 depicts a cable design incorporating a superconducting element of an inventive composition.

FIG. 6 depicts a superconducting solenoid.

FIG. 7 represents a superconducting torus suitable for use for fusion reaction confinement.

The element of FIG. 8 is representative of structures which advantageously make use of thin sheet material. The particular structure represented is a "Bitter" type magnet which is quite familiar to workers in the art. A recently filed U.S. patent application Serial No. 025,913, depends upon structures which include perovskite compositions produced, e.g., as tape, extruded rod, silk-screened patterns, etc. in which initial material is formed with the assistance of binder, subsequently removed to leave the fired superconducting material. Such structures are exemplary of forms suitably incorporating compositions of the invitation.

### Detailed Description

Most significantly, the origin of the invention is in terms of superconducting copper oxide compounds, basically of the perovskite structure, with mixed cation "A" site occupancy, as described in the "Summary". The responsible single phase material, here identified as "perovskite", naturally leads to total as well as partial substitutions; to establishment of criteria determinative of parameters such as cation concentrations, permitted oxygen content (always deficient in terms of the prototypical ABO₃ composition) as well as average valence state of the copper ion (crucial in terms of the mechanism which may be regarded as responsible for supplying conduction electrons). The role of the perovskite is crucial so long as the superconducting element is not a single crystal (e.g., in the ceramic form of many of the reported experiments herein). An important attribute has to do with facilitation of larger crystallites and as possibly aided by improved intergrain contact with resulting enhanced current-carrying capability.

### Structure

Materials of the invention are preferably single phase. By this it is meant that the materials herein are single phase preferably to at least 95 mole percent as determined by powder x-ray diffraction. The particular value, 95 percent, is chosen as corresponding with the expected measurement precision of ordinary apparatus - procedures. While such "truly" single phase material is to be preferred and will doubtless be the ambition for practical usage, compositional as well as preparatory considerations (e.g., film formation) leads to the more general requirement that materials be single phase to 75 mole percent. Even somewhat larger amounts of second phase material are permissible for uses in which maximum current density is not required.

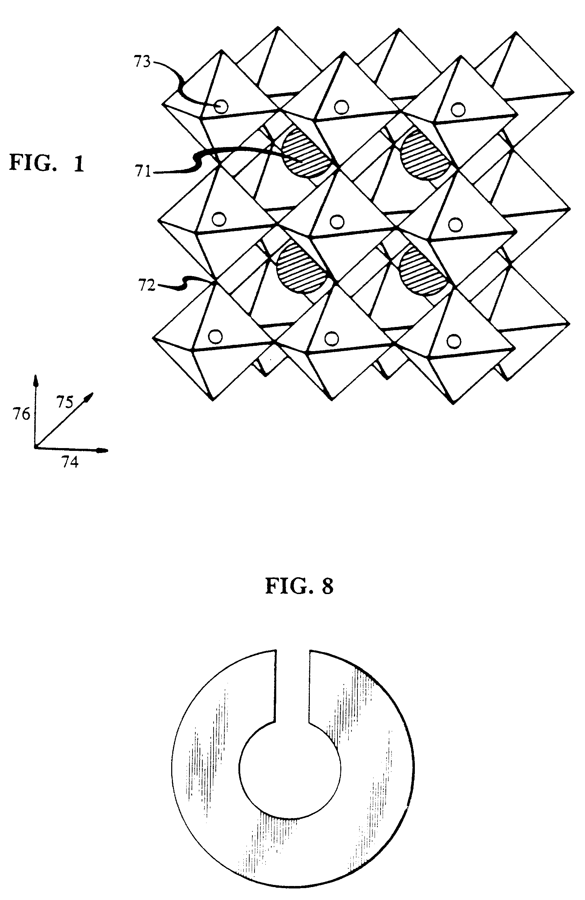

FIG. 1 presents the atomic arrangement of the unit cell of materials of the perovskite structure type. The structure has been described in detail in standard references. The symbols of the type marked by 71 are representative of he positions of the A site atoms in the prototype material; the corners of the octahedra as marked by 72 are representative of the oxygen atoms; and symbols of the type marked 73 are representative of the copper atoms. The unit cell represented in the Figure has cubic symmetry, that is, the elementary repeat distances in the directions denoted by arrows marked 74, 75 and 76 are equal in length to each other. There are many distortions and types of nonstoichiometry in perovskites which are detailed in standard references.

It is most significant that the single phase so identified is "perovskite". The quoted term as used herein is meant to include not only the prototype, truly cubic material, but very significantly distortions therefrom. As indicated, other variation from the nominal perovskite is in terms of stoichiometry. Analyzed materials of the invention show oxygen occupancy of 6.5-7.1, significantly below the nominal composition of 9 for a non-deficient perovskite. This translates into δ values of 1.9 to 2.5 in terms of the formula containing O_{9-δ}. A somewhat wider range is still expected to superconduct.

As with pre-invention perovskite copper oxide superconductors, there are two significant compositional contributions to the structure. These are discussed in more detail in a following section relating (a) to observed oxygen deficiencies which reduces the coordination number of a portion of the copper from six to five or possibly four, and (b) mixed occupancy of the "A site" (in the prototypical representation ABO₃), i.e., occupancy by at least three ions represented as M and M', in the general formula above -- gives rise to a further variation. X-ray diffraction studies, while indicating single phase material, translate into substantial ordering of the A-site ions in selected compositions which, in turn, gives rise to a unit cell size larger than that of the primitive cell corresponding with the single formula unit ABO₃. This is true for many compositions as modified in accordance with the invention. X-ray diffraction measurements of a preferred composition before modification--nominally Ba₂YCu₃O_{6.9} -- indicate a crystallographic unit cell of orthorhombic symmetry of size a=3.87, b=3.86, c=11.67 10⁻¹⁰m (Angstroms). This crystallographic cell is a "supercell" of the cubic ABO₃ and is of three times the volume due to subtle ordering effects. Other compositions may show different "supercells" or exhibit "supercells" whose diffraction signatures are too weak to be observed by conventional x-ray powder diffraction techniques. Such supercells are well known in perovskite structure type materials. Isolation of single crystalline material has permitted verification of the above. In compositions herein in which M and M' ions differ in size sufficiently (e.g., in terms of an ionic radius ratio of at least 1.2), these materials are truly ordered for compositions in which inclusion of M/M' ions nominally follows the ratio 2/1, and the repeating unit includes three primitive cells. While preferred compositions generally meet the ion size requirements for ordering, other superconducting compositions of the invention do not. So, for example, compositions which are predominantly M=Ba, M'=La, are based on M/M' radii which do not inherently result in ordering. Considerations such as material cost and ease of processing may lead to selection of such compositions which, in these terms, may be "disordered"--this is not altered by the inventive teaching.

### Composition

The prototypical composition has been described in terms of M₃₋ₘM$\frac{\text{'}}{\text{m}}$Cu₃O_{9-δ}. Oxygen content is critical and is set forth at the nominal value of 7 (9-δ=7). Permitted variations in measured compounds give rise to a suggested range of oxygen content in this formula of 1.5 < δ < 2.5, preferably δ ≦ 2.1. Compositions are generally such as to correspond with an average copper valence state of from 2.0 to 2.4 (2.0 < n < 2.4 for Cuⁿ⁺).

Prototypical compositions (compositions not yet substituted in accordance with the present requirements) are discussed in terms of permitted occupancies:
M=Barium (Ba)
M'=Yttrium (Y), Europium (Eu), Lanthanum (La),
Cu-materials of the invention are all nominally copper oxides. For these purposes, materials treated herein owe their superconducting properties to that fraction of the material which contains Cu in this site.

Compositions listed above are in no sense limiting. The inventive teaching, while certainly dependent upon superconducting copper oxide materials, derives primarily from mixed A site occupancy of "perovskite" material, as described, and is intended to include all superconducting compositions meeting these general requirements, whether or not containing the specific A site ions set forth.

As discussed, the invention depends upon mixed occupancy of A site ions--depends upon inclusion of at least one additional ion (X in one form of the nominal formula). Stated differently, the inventive concept depends upon inclusion of at least three chemically distinct atoms in the A site. The inventive result, whether expressed in terms of increased field, increased current, or a combination of the two, is dependent upon introduction of at least a third ion into the A site. Experimental evidence, as seen from the example table, is consistent with the inventive requirement in terms of substituent ions which do not destroy the relevant superconducting perovskite structure. It is seen that partial substitution for M and/or M' ions results in the inventive advance. Permitted partial substitutions for M' include many atoms which cannot serve as total M'/M substituents. (The required superconducting perovskite structure, as defined, is retained for partial substitutions of any of the lanthanide rare earths elements Nos. 57-71, as well as Sc, Ca, and Sr).

In common with understanding of more conventional superconductors, enhanced superconducting properties of the nature of those with which the invention is concerned may be described in terms of the resistivity of the composition at the point at which the material becomes non-superconducting. A particular composition (example 2) manifests a linear relationship between improvement (in terms of H_{c2}) and resistivity. This comparison is made on the basis of materials which were prepared in identical fashion but for the partial substitution required by the invention. While no requirement, observations to date based largely on observed increase in H_{c2}, suggest that the resistivity values alluded to scale with bulk resistivity values.

As set forth under the "Summary", an inventive requirement from the compositional standpoint is mixed occupancy in the A site (for either or both of the M and M' ions) in terms of inclusion of at least 1 at. % of a third A site ion (a third cation other than copper in the overall composition). Preferred compositions include at least 5 at.% in the same terms. Based on the fact that 25 at. % substitution yielded three-fold improvement in H_{c2}, a still more preferred compositional class is expressed in terms of at least 10 atomic % (yielding ^{∼}100% improvement in H_{c2}.

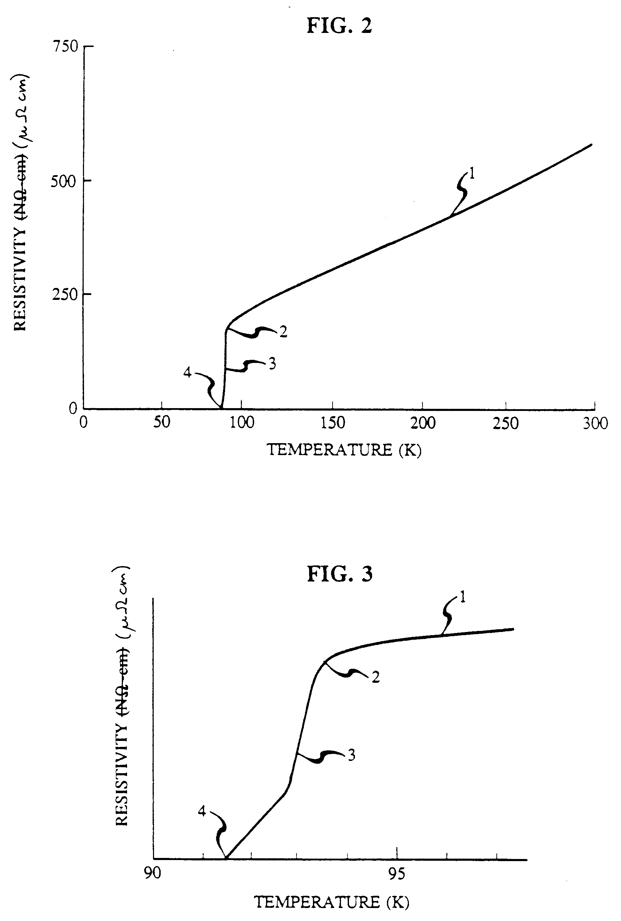

FIG. 2 is illustrative of the resistive technique for measuring superconductivity. The resistivity measurement ρ is made by a standard 4-point probe. The abscissa units are temperature in Kelvin, K. It is seen that curve 1 follows a constant slope upon decrease of temperature to about 110K, below which the resistivity decreases more quickly, followed by a more abrupt break 2 indicative of onset of superconductivity. Point 3 is the "mid-point resistive" value, in this instance occurring at 93K. Point 4 represents the temperature at which all resistance to the flow of electricity occurs and is 91.5K in this sample.

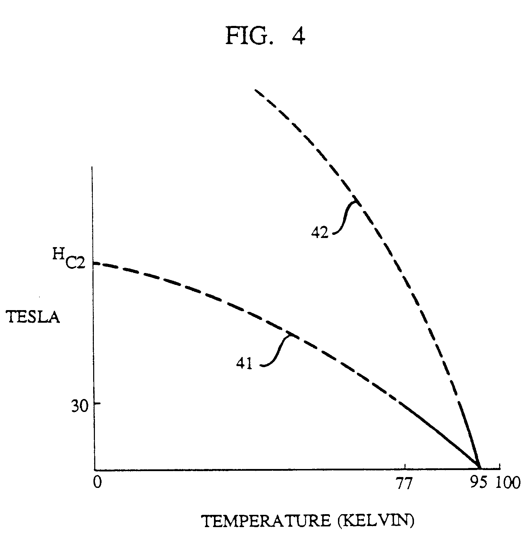

FIG. 3 is a blowup of FIG. 2 showing the same features in more detail. FIG. 4, in units of magnetization on the ordinate in terms of 10⁻² mAm² (emu) versus temperature in Kelvin on the abscissa, are illustrative of the results of magnetization measurements. The particular sample is that of Example 1. The procedure followed for this Example and for all others reported involved first cooling the sample to 4K, a magnetic field was then used in a commercial SQUID magnetometer. For the particular sample plotted, the field applied was 1472.2 A/m (18.5 Oe) resulting in a magnetization of -3.10⁻² mAm² (emu) at 10K and sharply turned up to become positive above 90K.

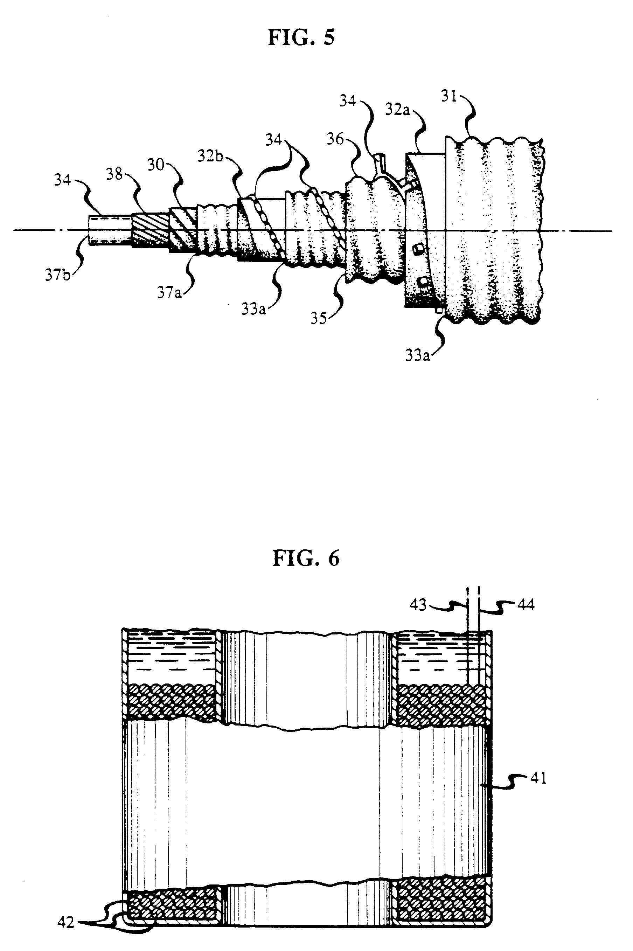

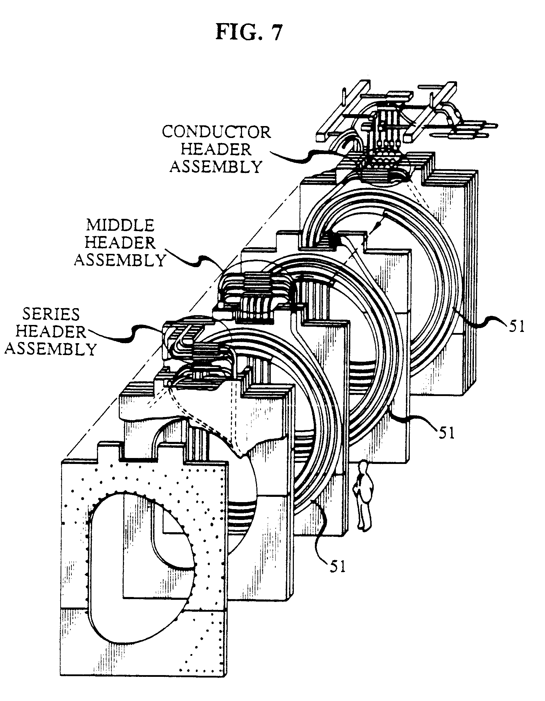

The structure shown in FIG. 5 is described in detail in G. Bogner, "Large Scale Applications of Superconductivity", Superconductor Application: SQUIDS and Machines, B. B. Schwartz and S. Foner, eds. (Plenum Press, New York, 1977). Briefly, the structure depicted consists of an outer sheathing 31, thermal insulation layers 32a and 32b, evacuated annular regions 33a and 33b, spacers 34, nitrogen-filled annular region 35, heat shield 36, and coolant regions 37a and 37b (it is a feature of the inventive structure that coolant may consist of liquid nitrogen in contradistinction with the liquid helium or hydrogen required of earlier structures). Element 38 is a superconductor material in accordance with the invention. FIG. 6 shows an annular cryostat 41 filled with liquid nitrogen and containing turns 42 of a material herein. Terminal leads 43 and 44 are shown emerging from the coil. The magnetic test structure of FIG. 7 is described in R. A. Hein and D. U. Gubser, "Applications in the United States", in Superconductor Materials Science; Metallurgy, Fabrication, and Applications, S. Foner and B. B. Schwartz, eds., (Plenum Press, New York, 1981). The superconducting element shown as windings 51 are made of a material herein. The structure is considered exemplary of those expected to find broad-scale use for containment of fusion reaction. And FIG. 8 schematically shows a slotted torus of the kind used to assemble a magnet of the "Bitter" type.

### Material Preparation

Material specification in accordance with the invention depends upon the nature of the intended use. For power transmission, or any other current-carrying application, it is required that there be a continuous superconducting path. For detector and other device use (e.g., Josephson junction devices) in which tunneling might be permitted or even required, it is necessary only that there be sufficient superconducting phase to satisfy such use.

For many purposes, it is an advantage of the invention that fabrication of superconducting elements may utilize standard ceramic processing.

Appropriate starting materials are mixtures of metallic oxides, hydroxides, carbonates, hydrates, oxalates, or other reactive precursors in the appropriate ratio to obtain the desired final composition. Starting material may be produced by wet or dry mixing, by co-precipitation of materials from solution, or by any other method which results in intimate mixture of reactive particles.

Mixtures of starting materials can be fired in air, oxygen or other non-reducing ambient at temperatures sufficient to facilitate chemical reaction between constituents and to begin formation of the desired phase. Firing temperatures as noted are composition-dependent so that choice of temperature may radically affect T_{c} for certain compositions. Typically, temperatures are between approximately 700 and 950°C for times of between a few hours and several days until the desired phase is either fully or partially produced. The "calcined" material is then formed into the ceramic body of desired shape by standard ceramic processing techniques such as hot or cold pressing, extrusion, slipcasting, or other such technique appropriate to the geometry of the desired (green body) object.

The material in final form is fired at a temperature sufficiently high to complete chemical reaction of components ("reactive sintering") if not accomplished in step (2) and for densification. This sintering is conducted so as to reduce voids to the point where the density of the ceramic body is sufficient to allow obtaining favorable electrical and mechanical properties. For most favorable results, the material is fired in an ambient environment with greater partial pressure of O₂ than that of air (0.02 MPa (.2 atm.)). However, material fired in air may have acceptable superconducting properties. (Air is not the desired processing environment since the use of too high a temperature may result in undue oxygen loss and consequently degradation of properties.)

While the description above is important for many purposes, material preparation may take other forms. An alternative is preparation of thin films for Josephson Junction and other devices. Workers in the field know of many film-forming procedures, e.g., magnetron sputtering, diode sputtering, reactive ion sputtering, ion-beam sputtering and other thin film deposition techniques including evaporation. "Conductor" structures may take on the form of continuous strands, however produced. Initial formation may utilize techniques as applied to other brittle glass-like material. In this approach, the structure reverts to one that is crystalline before attainment of superconductivity. One technique which has been applied to other brittle superconductors entails extrusion within a protective sheathing of copper or other ductile material.

Since the material is oxidic another approach may entail formation of an alloy of the designated metals followed by oxidation.

### Generalized Preparatory Approach as Used in the Examples

Here the procedure followed in each of the numbered examples is set forth:
1) Starting materials are powders of lanthanum hydroxide, strontium carbonate, calcium oxide, copper oxide, barium oxide, yttrium oxide, europium oxide, praseodymium oxide, and scandium oxide. While much of the work entailed relative high purity, many rare earths contain finite amounts of other rare earths which are difficult to remove. It is noteworthy that high purities are not required for preparation of suitable material.
2) Starting materials are weighed in appropriate quantities to yield the desired composition They are then further pulverized in a mortar and pestle.
3) Materials from step 2 are then fired (e.g., at 950°C for a period of approximately 16 hours).
4) In some cases the materials were pulverized and then refired in air or oxygen for 16 hours.
5) Materials are pulverized and pressed dry into shape suitable for experimentation at a pressure of between 34.47 and 68.95 MPa (between 5,000 and 10,000 psi). (In the examples reported the shape was that of a disc of approximately 1 cm diameter and 1 mm thick.
6) The discs are next fired at a temperature of about 950°C (materials of examples 3-6 and 9 were fired at about 700°C) for two hours in oxygen.
7) Materials are allowed to cool to ambient temperature in flowing oxygen gas.

As stated, the above conditions were for purpose of comparison. Other preliminary work has established the value of varying many of the conditions set forth. For example, the repeating of step 4 to assure a degree of uniformity can be omitted --may even desirably be omitted. Clearly, the temperatures stated are non-critical, the requirement being only that the required composition-phase is produced in sufficient quantity as described. Consistent with the description above, other considerations may dictate deliberate abbreviation in processing to avoid production of pure single-phase material.

The technique used to identify the nature of the final material is set forth: a portion of the finally annealed disc is pulverized, and a powder X-ray diffraction pattern is made. The particular technique used was powder diffractometry, although other techniques such as Debye-Scherrer or Guinier photography may also be employed. (D. D. Cullity, Elements of X-Ray Diffraction, Addison-Wesley Publ. Co., Inc., Reading, Mass. (1978)).

### Examples

Examples 2, 3, 5, 6, 7, 8, 9, 10, set forth in tabular form, show mixed A site occupancy as required by the invention. Examples 1 and 4 are included as reference (unmixed) compounds. For convenience, compositions set forth are in terms of resistivity as measured with the material having initially reverted to its non-superconducting state. It is well established that this is a sufficient criterion for improvement in superconducting properties. The first two entries, for example, correspond respectively to the prototypical unsubstituted BaY compound, and such a compound in which Y is replaced by 75 atomic % Eu resulted in three-fold improvement in H_{c2}. This is indicated by the measured slope increase in 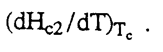
This increase is shown on FIG. 4. Curve 42 representing substituted material of the composition of example 2 has an increased slope compared with that of curve 41 representing unsubstituted material of the composition of example 1. This corresponds with an increase from 12 Tesla/Kelvin below T_{c} (95K) to 30 Tesla/Kelvin.

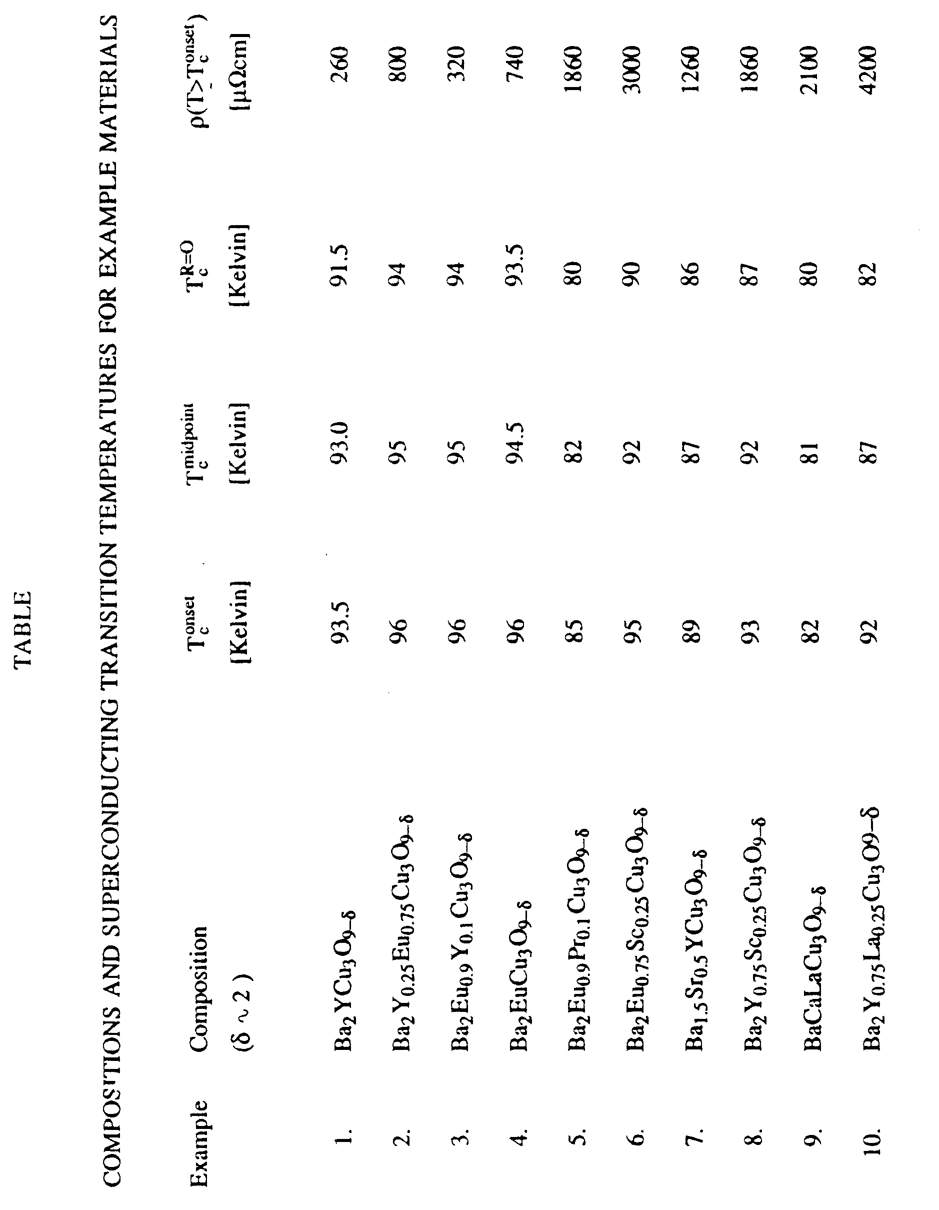

## Claims

1. An article comprising a quantity of material that exhibits superconducting properties at 77K or above, said material comprising Ba, Cu and oxygen,
CHARACTERIZED IN THAT
at least 75 mole % of said material is a single phase perovskite-like material of nominal composition Ba_{2-y}M'_{1-z}X_{y+z}Cu₃Oₓ (6.5 ≲ x ≲ 7.5; y < 1; z < 0.5; 1.0 > y + z > 0.03), where M' is one of Y, Eu and La, and X is other than M' and is at least one of Y, Sc, Ca, Sr, and the elements of atomic number 57-71; associated with said single phase perovskite-like material is a critical magnetic field H_{c} that exceeds by at least 10% the value of a corresponding critical magnetic field that is associated with an otherwise identical superconducting material wherein both y and z are zero.

2. The article of claim 1, wherein y + z > 0.15.

3. The article of claim 2, wherein y + z > 0.3.

4. The article of claim 1, wherein M' is Y and the quantity of material exhibits superconducting properties at 90K.

5. The article of claim 1, wherein M' is Eu and the quantity of material exhibits superconducting properties at 90K.

6. The article of claim 1, wherein at least 95 mole % of said material is said single phase perovskite-like material.

7. The article of any of claims 1-6, wherein x is 6.9.

## Patentansprüche

1. Gegenstand mit einer Menge eines Materials, das supraleitende Eigenschaften bei 77K oder oberhalb davon aufweist, wobei das Material Ba, Cu und Sauerstoff umfaßt,
dadurch gekennzeichnet,
daß wenigstens 75 Mol.% des Materials einphasiges Perovskitartiges Material der Nennzusammensetzung Ba_{2-y}M'_{1-z}X_{y+z}Cu₃Oₓ (6,5 < x < 7,5; y < 1; z < 0,5; 1,0 > y + z > 0,03) , wobei M' eines der Elemente Y, Eu oder La ist und
X anders als M' ist und wenigstens eines der Elemente Y, Sc, Ca, Sr oder der Elemente der Atomzahl 57-71 ist, wobei zu dem einphasigen Perovskit-artigen Material ein kritisches Magnetfeld H_{c} gehört, das um wenigstens 10 % den Wert eines entsprechenden kritischen Magnetfeldes überschreitet, das zu einem ansonsten identischen, supraleitenden Material, in welchem sowohl y als auch z gleich 0 sind, gehört.

2. Gegenstand nach Anspruch 1,
in welchem y + z > 0,15 sind.

3. Gegenstand nach Anspruch 2,
in welchem y + z > 0,3 sind.

4. Gegenstand nach Anspruch 1,
in welchem M' Y ist und die Menge an Material supraleitende Eigenschaften bei 90K aufweist.

5. Gegenstand nach Anspruch 1,
in welchem M' Eu ist und die Menge an Material supraleitende Eigenschaften bei 90K aufweist.

6. Gegenstand nach Anspruch 1,
in welchem wenigstens 95 Mol.% des Materials das einphasige Perovskit-artige Material sind.

7. Gegenstand nach einem der Ansprüche 1 bis 6,
in welchem x gleich 6,9 ist.

## Revendications

1. Un produit comprenant une quantité de matière qui présente des propriétés supraconductrices à 77°K ou supérieure à 77°K, ladite matière comprenant du Ba, du Cu et de l'oxygène,
caractérisé en ce que
un pourcentage molaire d'au moins 75% de ladite matière est une matière à phase unique du type pérovskite de composition nominale Ba_{2-y}M'₁₋₂X_{y+z}Cu₃Oₓ(6,5 ≦ x ≦ 7,5; y < 1; z < 0,5; 1,0 > y + z > 0,03), où M' est un élément choisi parmi Y, Eu et La, et X est autre que M' et est au moins un élément choisi parmi Y, Sc, Ca, Sr et les éléments à nombre atomique compris entre 57 et 71; à ladite matière à phase unique du type pérovskite est associé un champ magnétique critique H_{c} qui dépasse d'au moins 10% la valeur d'un champ magnétique de type correspondant qui est associé à une matière supraconductrice, qui pour le reste est identique, dans laquelle y et z sont l'un et l'autre nuls.

2. Le produit selon la revendication 1, dans lequel y + z > 0,15.

3. Le produit selon la revendication 2 dans lequel y + z > 0,3.

4. Le produit selon la revendication 1, dans lequel M' est Y et la quantité de matière présente des propriétés supraconductrices à 90°K.

5. Le produit selon la revendication 1, dans lequel M' est Eu et la quantité de matière présente des propriétés supraconductrices à 90°K.

6. Le produit selon la revendication 1, dans lequel un pourcentage molaire d'au moins 95% de ladite matière est une matière à phase unique de type pérovskite.

7. Le produit selon l'une quelconque des revendications 1 à 6 dans lequel x est 6,9.
